# FASCICULE DE BREVET EUROPEEN

(11) **EP 3 721 481 B1**
(45) Date de publication et mention de la délivrance du brevet: **03.08.2022**
(21) Numéro de dépôt: 18807639.2
(22) Date de dépôt: 29.11.2018
(51) Int. Cl.: H01L 31/048, H01L 31/18, H01L 31/054

(54) **FABRICATION D'UN SOUS-MODULE A CONCENTRATION INTEGRANT UN MATERIAU DISSIPATEUR DE CHALEUR**
HERSTELLUNG EINES KONZENTRIERENDEN TEILMODULS MIT EINEM WÄRMEABLEITENDEN MATERIAL
MANUFACTURING A CONCENTRATING SUB-MODULE COMPRISING A HEAT-DISSIPATING MATERIAL

(30) Priorité: 07.12.2017 FR 1761781
(43) Date de publication de la demande: 14.10.2020
(73) Titulaire: Commissariat à l'Energie Atomique et aux Energies Alternatives, 75015 Paris (FR)
(72) Inventeur: BARBOT, Anthony, 73000 Chambery (FR); ROUJOL, Yannick, 38890 Saint-Chef (FR); SERAINE, Caroline, 73800 Sainte-Helene-Du-Lac (FR); WEICK, Clément, 38000 Grenoble (FR)
(74) Mandataire: Marks & Clerk France
(86) Numéro de dépôt international: PCT/EP2018/082965
(87) Numéro de publication internationale: WO 2019/110408

(56) Documents cités:
- EP-A2- 1 715 260
- EP-B1- 1 715 260
- WO-A1-2009/002350
- WO-A2-2010/017422
- US-A1- 2013 081 668

## Description

L'invention concerne la fabrication d'éléments pour modules photovoltaïques à concentration, et plus particulièrement pour les modules photovoltaïques à concentration basés sur des concentrateurs paraboliques linéaires réfléchissants (ou miroirs). Ces éléments sont appelés sous-modules photovoltaïques à concentration.

Ces sous-modules comprennent chacun un dispositif optique de concentration de la lumière (souvent appelé miroir ou concentrateur) et des cellules photovoltaïques formant un récepteur photovoltaïque et disposées en face arrière du miroir ou concentrateur, à l'opposé de la face réfléchissante.

Lorsqu'ils sont mis en œuvre, ils permettent de former un module photovoltaïque à concentration, le concentrateur d'un sous-module présentant une ligne focale située au dos du concentrateur d'un sous-module voisin. Le récepteur photovoltaïque du sous-module voisin est situé au niveau de cette ligne focale. Ainsi, chaque miroir joue, en plus de son rôle de concentrateur, le rôle de support pour un récepteur photovoltaïque. Le module photovoltaïque à concentration consiste donc en un assemblage de plusieurs éléments généralement identiques, appelés sous-modules.

Le concentrateur ou miroir de ces sous-modules à concentration solaire possède une surface réfléchissante composée d'un miroir, et une face arrière sur laquelle une ou un ensemble de cellules photovoltaïques est fixé (voir les documents US 1993/5180441, US 2013/081668 A1 et WO 2010/017422 A2). La forme parabolique du module permet de concentrer les rayons lumineux. La lumière arrivant sur un premier sous-module est réfléchie par la surface réfléchissante du premier sous-module, de manière à concentrer la lumière sur la cellule photovoltaïque d'un second sous-module situé à proximité du premier module.

Il est également possible de réaliser un sous-module photovoltaïque, de forme parabolique, à concentration (voir le document US 2007 / 0256726), dans lequel la concentration de la lumière n'est pas faite sur le point focal d'un miroir, mais sur le point focal d'un élément solide complexe composé de plusieurs miroirs. Dans ce document, les cellules photovoltaïques sont placées sur la face avant du concentrateur. Afin d'éviter la formation de bulles d'air entre les différents composants du sous-module, plusieurs laminations sous vide sont réalisées pour intégrer l'optique, les cellules photovoltaïques et le câblage. La lamination sous vide permet ainsi d'assurer une meilleure adhésion de l'optique, des cellules ou du câblage sur leur support respectif en utilisant pas ou peu de colle. Comme ces différentes laminations forment une structure composite planaire, il y a une autre étape de fabrication, durant laquelle des miroirs sont fixés à des surfaces convexes ou concaves, pour donner la forme parabolique, servant à concentrer la lumière sur le point focal de l'élément solide optique.

Le document US 2004 / 0118395 présente un concentrateur solaire parabolique comprenant une structure en nid d'abeilles entourée de deux peaux. Cette structure en nid d'abeilles permet d'avoir un concentrateur léger, capable de supporter des miroirs fins ou une surface réfléchissante fine tout en ayant une bonne tenue mécanique. Néanmoins, cet élément ne comporte aucune cellule photovoltaïque, car il est destiné au chauffage d'un fluide. De plus, il est fabriqué en plusieurs étapes, notamment la déformation à froid de la surface réfléchissante, la fixation des miroirs avec une colle sur l'une des peaux, et le traitement de surface des peaux et des miroirs.

La surface réfléchissante peut être composée d'une couche d'un métal fortement réfléchissant recouverte d'un film protecteur, ou composée d'une couche métallique collée à un substrat comprenant des matériaux composites organiques (voir le document US 1994 / 5344496). Un maillage d'un matériau à forte conductivité thermique peut également être ajouté à l'arrière de la surface réfléchissante pour améliorer la dissipation de chaleur du sous-module. La fabrication de ces sous-modules est assez complexe, car elle nécessite de nombreuses étapes, comme la formation et le polissage de la surface réfléchissante, ou le traitement de cette surface. Il faut aussi prévoir une étape de collage des cellules photovoltaïques sur le miroir.

L'utilisation de matériaux composites pour les sous-modules solaires à concentration permet d'obtenir des sous-modules légers et rigides, cependant la conductivité thermique de ces matériaux est plus faible que celle de certains métaux, notamment de l'aluminium. Or l'augmentation de température sur le sous-module a pour effet de faire baisser le rendement des cellules photovoltaïques et d'en diminuer la durée de vie.

Afin d'améliorer la dissipation thermique des modules photovoltaïques plans, utilisés par exemple sur les toits des bâtiments, il est possible d'utiliser un radiateur massique composé de graphite (voir le document US 2010/0186806) ou une feuille de graphite (voir le document WO 2012/044017). Le radiateur ou la feuille de graphique sont placés au dos du module photovoltaïque, sous les cellules photovoltaïques afin d'en limiter la montée en température. Néanmoins, ces solutions nécessitent des étapes supplémentaires lors de fabrication du module ou ne permettent pas de fabriquer des modules solaires à concentration légers et rigides.

L'invention vise à remédier aux inconvénients précités de l'art antérieur, plus particulièrement elle vise à proposer un procédé de fabrication, ne comportant qu'une seule étape, d'un sous-module photovoltaïque à concentration intégrant un matériau dissipateur de chaleur.

Un objet de l'invention est donc un procédé de fabrication selon la revendication 1 d'un sous-module solaire photovoltaïque à concentration, muni d'une face réfléchissante ayant une forme géométrique prédéfinie concave, caractérisé en ce que le procédé comprend la lamination, en une seule étape, d'un ensemble multi-couches comprenant successivement un élément structurel muni d'une première face réfléchissante et d'une seconde face, opposée à la première, une couche d'un matériau de bonne conductivité thermique, supérieure à celle du matériau composant l'élément structurel placée sur la seconde face de l'élément structurel, une couche d'encapsulant ou de colle, un récepteur photovoltaïque, la couche d'encapsulant ou de colle étant placée entre la couche d'un matériau de bonne conductivité thermique et le récepteur, une couche en matériau d'encapsulation transparent, recouvrant au moins toute la surface du récepteur photovoltaïque, et une couche de protection transparente recouvrant la couche en matériau d'encapsulation transparent, et caractérisé en ce que pendant la lamination, la face réfléchissante de l'élément structurel est mise en forme par mise en contact avec une surface convexe d'une contre-forme, pour obtenir la face réfléchissante de forme géométrique prédéfinie concave.

Selon des modes de réalisation particuliers de l'invention :
- La forme géométrique prédéfinie concave de ladite face réfléchissante peut être parabolique ;
- L'élément structurel peut être en matériau composite ;
- Le matériau de bonne conductivité thermique peut être le graphite, et plus particulièrement une feuille de graphite d'épaisseur comprise entre 50 µm et 500 µm ;
- Le matériau de bonne conductivité thermique peut être le graphène ;
- Le matériau d'encapsulation transparent et la couche de protection transparente peuvent recouvrir ledit matériau de bonne conductivité thermique sur toute sa surface, de manière à le protéger; et
- Le matériau de bonne conductivité peut recouvrir toute la surface de la seconde face de l'élément structurel.

D'autres caractéristiques, détails et avantages de l'invention ressortiront à la lecture de la description faite en référence aux figures annexées données à titre d'exemple et qui représentent, respectivement :
- La figure la, une coupe d'un module composé de deux sous-modules illustrant le fonctionnement d'un module photovoltaïque à concentration ;
- La figure 1b, les dimensions caractéristiques d'un module photovoltaïque à concentration ;
- La figure 2, une illustration d'un procédé de fabrication d'un sous-module photovoltaïque à concentration ;
- La figure 3, une illustration d'un procédé de fabrication d'un sous-module photovoltaïque à concentration selon un mode de réalisation de l'invention ;
- La figure 4, un graphique de la température le long d'un sous-module photovoltaïque à concentration en fonctionnement selon un mode de réalisation de l'invention ; et
- La figure 5, un graphique de l'intensité et de la puissance de trois sous-modules photovoltaïques à concentration en fonction de leur tension.

Les éléments présentés dans les figures ne sont pas à l'échelle, les proportions ne sont donc pas représentatives de la réalité.

La lamination est une étape de mise sous pression à chaud pour coller et presser deux ou plusieurs couches de matière. La pression et la température de cette étape sont dépendantes des matériaux employés. La lamination permet ici la mise en forme du concentrateur par application sur une contre-forme.

La figure la présente une coupe de deux sous-modules photovoltaïques à concentration illustrant le fonctionnement d'un module photovoltaïque à concentration. Seuls deux sous-modules M1 et M2 sont présentés, mais le fonctionnement décrit ci-dessous peut s'appliquer à une multitude de sous-modules. Des rayons lumineux RL arrivent sur une première face FR réfléchissante d'un premier sous-module M1. La face FR réfléchissante est habituellement constituée d'un miroir cylindrique parabolique. La forme parabolique du miroir du sous-module M1 permet de faire converger les rayons lumineux RL vers le foyer du miroir dont la position est précisément calculée afin d'y placer un récepteur photovoltaïque R. Cette position correspond également à un point sur une deuxième face FA d'un second sous-module M2. Les miroirs paraboliques ont des fonctions thermique, structurelle et optique. En effet, en plus de concentrer la lumière en un point, ils permettent de dissiper la chaleur avec une température maximale Tₘₐₓ au niveau du récepteur R et une température minimale Tₘᵢₙ sur la partie inférieure du sous-module, le récepteur R étant positionné sur la partie supérieure. La dissipation de chaleur est représentée par les flèches sur la figure, et la flèche reliant Tₘₐₓ à Tₘᵢₙ représente le gradient de température le long du sous-module (US 1993 / 5180441). Pour pouvoir réaliser un système à plusieurs sous-modules, la deuxième face FA du sous-module M1 peut également porter un récepteur photovoltaïque et la face FR du sous-module M2 peut être réfléchissante.

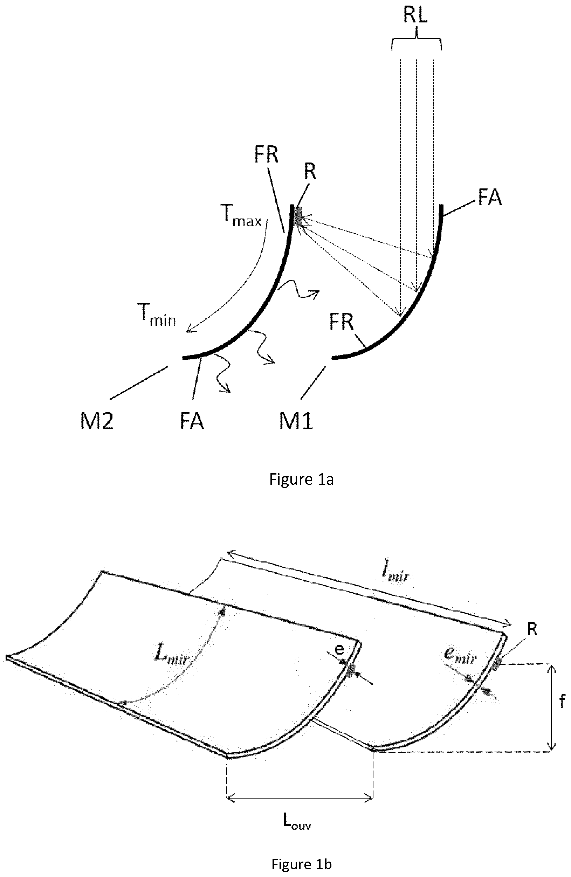

La figure 1b présente les dimensions caractéristiques d'un module photovoltaïque à concentration. La forme donnée aux sous-modules est une portion de parabole de distance focale f. La largeur développée de cette portion de parabole est donnée par Lₘᵢᵣ. La distance entre deux sous-modules est donnée par Lₒᵤᵥ. La longueur des sous-modules est donnée par Iₘᵢᵣ, l'épaisseur du concentrateur par eₘᵢᵣ et celle du sous-module par e.

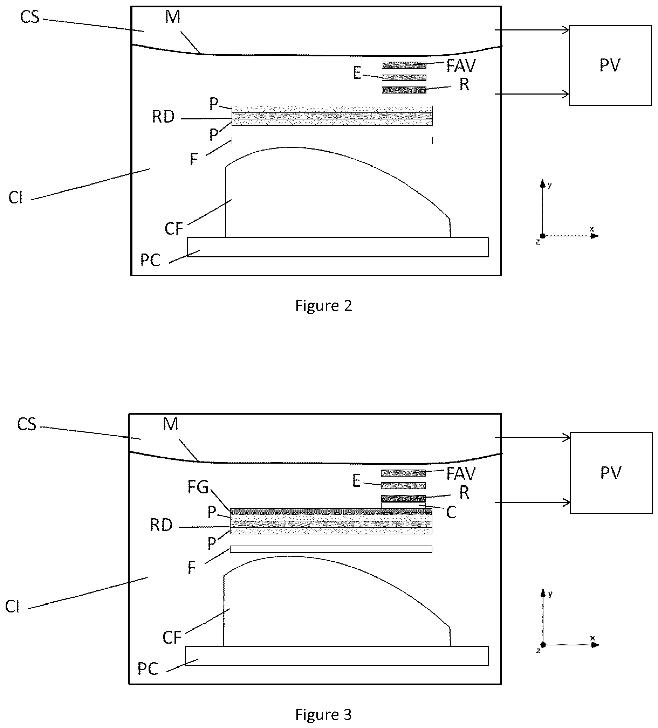

La figure 2 présente une illustration d'un procédé de fabrication d'un sous-module photovoltaïque à concentration. Une couche transparente FAV, recouvrant un encapsulant transparent E, lui-même recouvrant un récepteur photovoltaïque R, et un élément structurel sont placés sur une contre-forme CF dans la chambre inférieure CI d'un laminateur, et plus particulièrement d'un laminateur tel que ceux utilisés dans le domaine de fabrication des modules photovoltaïques classiques plans.

L'élément structurel a une face réfléchissante et il comprend en particulier une âme RD, également appelée matériau de renfort, entourée de deux peaux P, dont l'une est recouverte d'un film réfléchissant F.

La couche transparente FAV et l'encapsulant E recouvrent au moins toute la surface du récepteur R, le récepteur R étant placé entre l'élément structurel et l'encapsulant E.

L'élément structurel et le film réfléchissant R ont la même surface que le sous-module désiré.

Les chambres inférieure CI et supérieure CS du laminateur sont mises sous vide grâce à une pompe à vide PV.

L'ensemble couche transparente FAV, encapsulant transparent E, récepteur photovoltaïque R, peaux P, âme RD et film réfléchissant F, noté (FAV, E, R, P, RD, P, F), est plan et subit une lamination à chaud, de préférence sous vide, avec une mise en forme à l'aide de la contre-forme CF.

La contre-forme CF permet de définir la forme parabolique concave de la face réfléchissante du sous-module lors de l'étape de lamination. Elle présente donc une surface destinée à être en contact direct avec la face réfléchissante de l'élément structurel lors de l'étape de lamination. Cette surface a une géométrie pré-définie correspondant à la forme que l'on souhaite obtenir pour la face réfléchissante de l'élément structurel. La contre-forme CF peut être en matériau métallique ou composite, et est recouverte d'une couche anti-adhésive (en Téflon, par exemple). Le matériau de la contre-forme CF est choisi de manière à être un conducteur thermique et à présenter une bonne tenue mécanique à la température de lamination.

Les conditions de température, pression et de durée de cette étape de lamination sont adaptées par l'homme du métier en fonction des matériaux à laminer. A titre d'exemple, l'étape de lamination peut au moins durer 15 minutes, la température de la lamination est avantageusement comprise entre 120 °C et 170 °C et la pression de lamination peut être d'environ 1000 mbar (10⁵ Pa).

L'épaisseur de l'ensemble est de préférence inférieure à 10 mm afin de maintenir et d'assurer une forme parabolique optimale à l'ensemble. L'épaisseur peut également être limitée par la hauteur utile du laminateur et de la contre-forme CF. Durant la lamination, la contre-forme CF et l'ensemble (FAV, E, R, P, RD, P, F) reposent par exemple sur une plaque chauffante PC et une charge verticale homogène est appliquée progressivement sur le dessus grâce à la membrane M, épousant parfaitement les formes. Durant la lamination, il est nécessaire de réticuler suffisamment l'encapsulant E et de cuire correctement les différents éléments composant le module qui sont situés à des distances plus ou moins proches du plateau chauffant PC. Pour cela, le programme de lamination à chaud est optimisé en température, pression, et durée selon les matériaux utilisés.

Les peaux P peuvent être en matériau préimprégné polymère / fibre, qui permet d'obtenir l'adhésion du film réfléchissant F avec l'âme RD. Le préimprégné a une épaisseur inférieure à 200 µm et le pourcentage de résine est compris entre 40 et 55 %. Le polymère est choisi parmi du polyester, de l'époxy ou de l'acrylique, tandis que la fibre est choisie parmi du verre, du carbone, ou de l'aramide.

L'âme RD du matériau composite MC peut être une structure en nid d'abeilles en aramide de type Nomex, en polypropylène, en polycarbonate ou en aluminium.

L'âme RD peut également être une mousse en PET (polytéréphtalate d'éthylène), PU (polyuréthane), PVC (polychlorure de vinyle), PEI (polyéthérimide) ou en PMI (polyméthyneimine).

L'encapsulant transparent E peut avoir une épaisseur inférieure à 500 µm et être en élastomère réticulé, tel que l'EVA (éthylvinylacétate), ou en élastomère thermoplastique ou en copolymère thermoplastique réticulé ioniquement (IONOMER). Dans le cas d'un élastomère thermoplastique, l'encapsulant E est plus particulièrement en polyoléfine, en silicone, en PU thermoplastique, en polyvinyl butyral ou en polyoléfine fonctionnelle.

La couche transparente FAV peut avoir une épaisseur inférieure à 200 µm et être en ECTFE (ou HALAR, copolymère d'éthylène de chlorotrifluoroéthylène), FEP (fluoroéthylène propylène), PMMA (polyméthcrylate de méthyle), PC (polycarbonate), ETFE (éthylène tétrafluoroéthylène), PVDF (fluorure de polyvinylidène), PET, verre mince ou en CPI (polyimide transparent).

Le film réfléchissant F peut être un film polymère avec un dépôt d'aluminium ou avec un dépôt d'argent. L'idéal est que le film réfléchissant F soit suffisamment épais pour que l'éventuel renfort 3D RD en nid d'abeilles ne soit pas visible sur la surface réfléchissante du module, afin de ne pas perturber la concentration la lumière, tout en gardant un poids total du sous-module faible. Avantageusement le film a une épaisseur comprise entre 200 et 250 µm.

Le récepteur photovoltaïque R est composé de cellules photovoltaïques interconnectées par des fils (wire-bonding) et montées sur un récepteur de type SMI-PCB (Insulated Metal Substrate - Printed Circuit Board ou circuit imprimé sur un substrat métallique isolé) par brasage ou collage en utilisant, par exemple, une colle d'argent conductrice. Les cellules peuvent également être interconnectées entre elles par rubans ce qui permet de ne pas utiliser de récepteur SMI-PCB. Les cellules peuvent être des cellules en silicium ou des cellules multi-jonctions en matériaux semi-conducteurs de type III-V ou de type II-VI ou en matériau ayant une structure perovskite sur silicium.

Un exemple de mise en œuvre de fabrication d'un sous-module photovoltaïque est le suivant :
- La couche transparente FAV est en HALAR (ECTFE) ou en FEP avec une épaisseur de 25 µm et un grammage de 54 g/m² ;
- L'encapsulant transparent E est en ionomère avec une épaisseur de 50 µm et un grammage de 45 g/m² ;
- Le récepteur photovoltaïque R est constitué de cellules solaires triple-jonction de largeur 10 mm et de longueur 10 mm et d'un récepteur PCB-SMI d'épaisseur 75 µm ;
- L'âme RD est une âme en nid d'abeilles en aluminium d'épaisseur 3 mm et de grammage 78 g/m² entourée de deux peaux P en préimprégné carbone / epoxy de grammage 110 g/m² ;
- Le film réfléchissant F est constitué d'un film réfléchissant en PET, d'un dépôt aluminisé et d'un vernis de protection, le film F ayant une épaisseur de 71 µm et un grammage de 105 g/m².

L'ensemble est déposé sur une contre-forme CF en aluminium, ayant une forme parabolique de hauteur 28 mm, dans la chambre inférieure CI d'un laminateur, de hauteur utile 35 mm. La température de la plaque chauffante est de 150 °C. La chambre inférieure CI est dégazée pendant 300 s : les chambres inférieure CI et supérieure CS sont mises sous vide grâce à la pompe à vide PV. Puis durant une seconde phase de 600 s, une charge verticale homogène (à l'aide de la membrane M) est appliquée progressivement sur le dessus de la contre-forme CF, posée sur la plaque chauffante PC, à une vitesse de 1400 mbar/min jusqu'à un palier de 1000 mbar.

Les sous-modules ont une largeur développée Lₘᵢᵣ de 180 mm, une longueur Imir de 1 m et une largeur de cellules de 10 mm. Leur distance focale f est de 75 mm et la distance entre deux sous-modules est de Louv = 150 mm.

L'élément structurel peut comprendre un miroir en aluminium ayant une épaisseur inférieure à 0,5 mm. L'ensemble couche transparente FAV, encapsulant E, récepteur photovoltaïque R et miroir en aluminium subit une lamination en une seule étape sur une contreforme CF de la même manière que précédemment. Dans ce cas, le poids total du sous-module est légèrement supérieur (30 %). Sa tenue mécanique est plus faible et il nécessitera donc des supports complémentaires : trois supports sont en effet nécessaires pour un sous-module de longueur 1 m alors que deux supports sont nécessaires pour un sous-module de même dimension en matériau composite. Cependant, sa durée de vie est supérieure, car sa partie réfléchissante se dégrade moins contrairement aux couches organiques.

La figure 3 présente une illustration d'un procédé de fabrication d'un sous-module photovoltaïque à concentration selon un mode de réalisation de l'invention. Une couche de colle ou d'encapsulant C et une couche d'un matériau de bonne conductivité thermique FG, dite couche dissipative, sont ajoutées entre l'élément structurel et le récepteur photovoltaïque R. La couche dissipative FG est placée sur la surface de l'élément structurel et la couche de colle ou d'encapsulant C permet de maintenir en place le récepteur R sur la couche dissipative FG. Le matériau constituant la couche dissipative FG a une conductivité thermique supérieure à celle du matériau composant l'élément structurel, afin de pouvoir dissiper efficacement la chaleur le long du sous-module, et notamment au niveau du récepteur photovoltaïque R. Avantageusement, ce matériau a une conductivité thermique proche de celle de l'aluminium, c'est-à-dire supérieure à 100 W/(m.K), et une densité faible de manière à réaliser un sous-module léger capable de dissiper la chaleur de manière aussi efficace qu'un sous-module comprenant un miroir en aluminium. Ce matériau peut, par exemple, être du graphite. En effet, la densité du graphite est de 1,35 g/cm³ et sa conductivité thermique est de 140 W/(m.K) dans les directions x et y et de 8 W/(m.K) dans la direction z, tandis que l'aluminium a une conductivité thermique de 237 W/(m.K) et une densité de 2,7 g/cm³.

Selon un autre mode de réalisation de l'invention, la couche transparente FAV et l'encapsulant E peuvent recouvrir toute la surface de la couche dissipative afin de la protéger. La couche dissipative FG peut recouvrir toute la surface de l'élément structurel ou seulement une partie. Dans ce dernier cas, la couche dissipative FG a une épaisseur supérieure au cas où elle recouvrirait toute la surface de l'élément structurel. Néanmoins, elle recouvre au moins la surface de l'élément structurel sous le récepteur photovoltaïque R, car il est important de pouvoir dissiper la chaleur accumulée au niveau du récepteur R, pour éviter la diminution du rendement du récepteur R et en augmenter sa durée de vie.

Selon un mode de réalisation de l'invention, le matériau de bonne conductivité thermique constituant la couche dissipative FG est en graphite ou en graphène. Plus particulièrement, elle est en graphite d'épaisseur comprise entre 50 µm et 500 µm, afin d'assurer une bonne dissipation de chaleur, tout en restant souple et légère.

Le sous-module comprenant la couche dissipative FG et la couche de colle ou d'encapsulant C est assemblé lors d'une lamination à chaud, de préférence sous vide, avec une mise en forme à l'aide de la contre-forme CF.

Comme indiqué précédemment, la contre-forme CF permet de définir la forme parabolique concave de la face réfléchissante du sous-module lors de l'étape de lamination, et le programme de lamination à chaud est optimisé en température, pression, et durée selon les matériaux utilisés.

Selon un autre mode de réalisation de l'invention, la couche d'encapsulant ou de colle C est en EVA, polyoléfine, silicone, polyuréthane thermoplastique, polyvinyl butyral, polyoléfine fonctionnelle ou en ionomère. Généralement, le même matériau est utilisé pour la couche de colle ou d'encapsulant C et l'encapsulant E.

Le choix des matériaux constituant les sous-modules dépend du poids du sous-module visé, du respect de la forme parabolique assurant une bonne concentration, des conditions d'environnement du module (terrestre, stratosphérique ou spatial), et de la dissipation de chaleur souhaitée.

Le choix des matériaux constituant les sous-modules dépend du poids du sous-module visé, du respect de la forme parabolique assurant une bonne concentration, des conditions d'environnement du module (terrestre, stratosphérique ou spatial), et de la dissipation de chaleur souhaitée. Ainsi, en utilisant un préimprégné carbone / epoxy, de grammage compris entre 80 g/m² et 300 g/m², associé à un nid d'abeilles en aluminium d'une épaisseur de 3 mm pour l'élément structurel, on peut réaliser un sous-module, sans couche dissipative, rigide et d'un poids faible, bien inférieur à celui d'un module classique (différence de 30 %). Si une couche dissipative de graphite est ajoutée, le poids du sous-module sera alors le même que celui d'un module classique, mais il restera, néanmoins, plus rigide qu'un sous-module classique.

Un exemple de mise en œuvre de fabrication d'un sous-module photovoltaïque selon un des modes de réalisation de l'invention est le suivant :
- La couche transparente FAV est en HALAR (ECTFE) ou en FEP avec une épaisseur de 25 µm et un grammage de 54 g/m² ;
- L'encapsulant transparent E et la couche de colle ou d'encapsulant C sont en ionomère avec une épaisseur de 50 µm et un grammage de 45 g/m² ;
- Le récepteur photovoltaïque R est constitué de cellules solaires triple-jonction de largeur 10 mm et de longueur 10 mm et d'un récepteur PCB-SMI d'épaisseur 75 µm ;
- La couche dissipative FG est une feuille de graphite avec une épaisseur de 130 µm ;
- L'âme RD est une âme en nid d'abeilles en aluminium d'épaisseur 3 mm et de grammage 78 g/m² entourée de deux peaux P en préimprégné carbone / epoxy de grammage 110 g/m² ;
- Le film réfléchissant F est constitué d'un film réfléchissant en PET, d'un dépôt aluminisé et d'un vernis de protection, le film F ayant une épaisseur de 71 µm et un grammage de 105 g/m².

L'ensemble subit une lamination sur une contra-forme CF, la lamination et la contre-forme ayant les mêmes caractéristiques que l'exemple précédemment décrit de mise en œuvre de fabrication d'un sous-module photovoltaïque ne comprenant pas de couche dissipative FG.

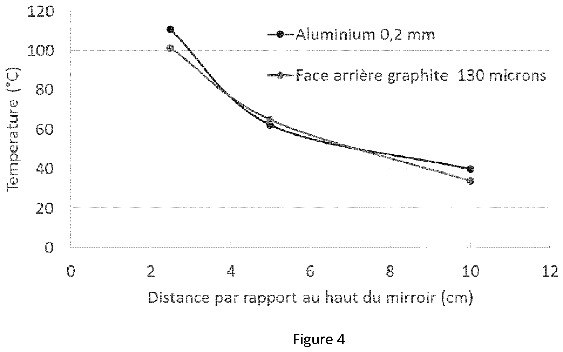

La figure 4 compare la température le long de deux sous-modules photovoltaïques à concentration en fonctionnement selon la distance par rapport au haut du miroir. Sur l'axe des abscisses, la distance 2,5 cm correspond à l'emplacement de la focale et donc du récepteur photovoltaïque R sur les deux sous-modules. Un module photovoltaïque comprenant une feuille de graphite de 130 µm, réalisé selon l'exemple de fabrication cidessus, a ainsi une dissipation de chaleur quasi-identique à celle d'un sous-module dont l'élément structurel est un miroir en aluminium d'épaisseur 0,2 mm et ne comprenant pas de feuille de graphite.

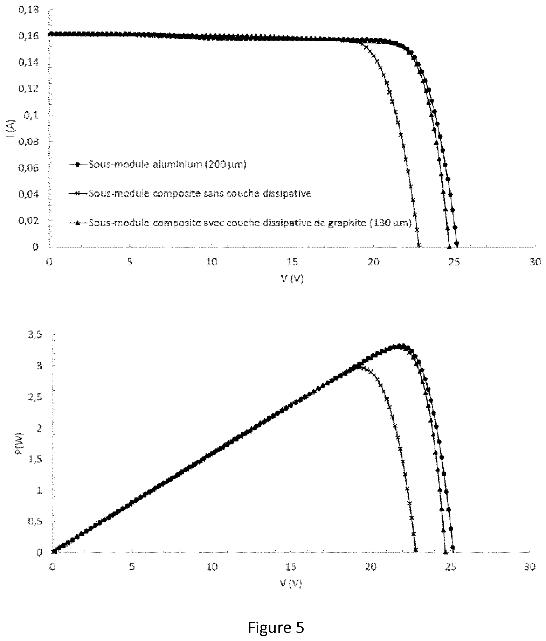

La figure 5 compare les valeurs d'intensité et de puissance de trois sous-modules selon leur tension, pour une illumination en extérieur à 735 W/m². Les trois sous-modules comparés sont respectivement un sous-module dont l'élément structurel est un miroir en aluminium d'épaisseur 200 µm et deux sous-modules dont l'élément structurel comprend une âme entourée de deux peaux, l'un des deux sous-modules comprenant en plus une couche dissipative de graphite d'épaisseur 130 µm. L'illumination continue, à 735 W/m², des sous-modules étudiées provoque une élévation de la température plus ou moins importante en fonction des matériaux utilisés. Or une élévation de la température se traduit directement par une chute de tension et donc un abaissement du point de puissance maximale. Un sous-module comprenant une âme entourée de deux peaux, sans couche dissipative, enregistre alors une chute de puissance de 10 %, comparé à un sous-module comprenant un miroir en aluminium. L'ajout d'une couche dissipative de graphite sur toute la surface de l'élément structurel permet de corriger ce phénomène, et d'obtenir une efficacité équivalente et une tenue mécanique bien supérieure à celles du sous-module comprenant un miroir en aluminium.

## Revendications

1. Procédé de fabrication d'un sous-module solaire photovoltaïque à concentration , muni d'une face réfléchissante ayant une forme géométrique prédéfinie concave, **caractérisé en ce qu'**il comprend la lamination, en une seule étape, d'un ensemble multi-couches comprenant successivement :
- Un élément structurel (F, P, RD) muni d'une première face réfléchissante (F) et d'une seconde face, opposée à la première ;
- Une couche dissipative (FG) d'un matériau de conductivité thermique supérieure à celle du matériau composant l'élément structurel, ladite couche dissipative placée sur la seconde face de l'élément structurel ;
- Une couche d'encapsulant (C) ou de colle;
- Un récepteur photovoltaïque (R) la couche d'encapsulant ou de colle étant placée entre la couche dissipative et le récepteur ;
- Une couche en matériau d'encapsulation (E) transparent, recouvrant au moins toute la surface du récepteur photovoltaïque ; et
- Une couche de protection (FAV) transparente recouvrant la couche en matériau d'encapsulation transparent ;
et **en ce que**, pendant la lamination, la face réfléchissante de l'élément structurel est mise en forme par mise en contact avec une surface convexe d'une contre-forme (CF), pour obtenir la face réfléchissante de forme géométrique prédéfinie concave.

2. Procédé de fabrication d'un sous-module solaire photovoltaïque à concentration selon la revendication précédente dans lequel la forme géométrique prédéfinie concave de ladite face réfléchissante est parabolique.

3. Procédé de fabrication d'un sous-module solaire photovoltaïque à concentration selon l'une des revendications précédentes dans lequel ledit élément structurel est en matériau composite.

4. Procédé de fabrication d'un sous-module solaire photovoltaïque à concentration selon l'une des revendications précédentes dans lequel ledit matériau de la couche dissipative est le graphite.

5. Procédé de fabrication d'un sous-module solaire photovoltaïque à concentration selon la revendication précédente dans lequel ladite feuille de graphite a une épaisseur comprise entre 50 µm et 500 µm.

6. Procédé de fabrication d'un sous-module solaire photovoltaïque à concentration selon l'une des revendications 1 à 3, dans lequel ledit matériau de la couche dissipative est le graphène.

7. Procédé de fabrication d'un sous-module solaire photovoltaïque à concentration selon l'une des revendications précédentes, dans lequel ledit matériau d'encapsulation transparent et ladite couche de protection transparente recouvrent ladite couche dissipative sur toute sa surface, de manière à le protéger.

8. Procédé de fabrication d'un sous-module photovoltaïque à concentration selon l'une des revendications précédentes, dans lequel ladite couche dissipative recouvre toute la surface de la seconde face de l'élément structurel.

## Patentansprüche

1. Verfahren zur Herstellung eines konzentrierenden Solar-Fotovoltaik-Teilmoduls, versehen mit einer reflektierenden Seite, welche eine vorbestimmte konkave geometrische Form aufweist, **dadurch gekennzeichnet, dass** es die Laminierung einer mehrschichtigen Anordnung in einem Schritt umfasst, welche nacheinander Folgendes umfasst:
- ein Strukturelement (F, P, RD), versehen mit einer ersten reflektierenden Seite (F) und einer zweiten Seite, welche der ersten Seite gegenüber liegt;
- eine Ableitungsschicht (FG) aus einem Material mit höherer Wärmeleitfähigkeit als derjenigen des Materials, aus welchem das Strukturelement besteht, wobei die Ableitungsschicht auf der zweiten Seite des Strukturelements platziert ist;
- eine Schicht aus Verkapselungsmittel (C) oder Klebstoff;
- einen Fotovoltaik-Empfänger (R), wobei die Schicht aus Verkapselungsmittel oder Klebstoff zwischen der Ableitungsschicht und dem Empfänger platziert ist;
- eine Schicht aus transparentem Verkapselungsmaterial (E), welche mindestens die gesamte Fläche des Fotovoltaik-Empfängers bedeckt; und
- eine transparente Schutzschicht (FAV), welche die Schicht aus transparentem Verkapselungsmaterial bedeckt;
und dadurch, dass, während der Laminierung, die reflektierende Seite des Strukturelements durch Inkontaktbringen mit einer konvexen Fläche einer Gegenform (CF) in Form gebracht wird, um die reflektierende Seite vorbestimmter geometrischer konkaver Form zu erzielen.

2. Verfahren zur Herstellung eines konzentrierenden Solar-Fotovoltaik-Teilmoduls nach dem vorhergehenden Anspruch, wobei die vorbestimmte geometrische konkave Form der reflektierenden Seite parabelförmig ist.

3. Verfahren zur Herstellung eines konzentrierenden Solar-Fotovoltaik-Teilmoduls nach einem der vorhergehenden Ansprüche, wobei das Strukturelement aus Verbundstoff besteht.

4. Verfahren zur Herstellung eines konzentrierenden Solar-Fotovoltaik-Teilmoduls nach einem der vorhergehenden Ansprüche, wobei das Material der Ableitungsschicht Graphit ist.

5. Verfahren zur Herstellung eines konzentrierenden Solar-Fotovoltaik-Teilmoduls nach dem vorhergehenden Anspruch, wobei die Graphitfolie eine Dicke aufweist, welche zwischen 50 µm und 500 µm beträgt.

6. Verfahren zur Herstellung eines konzentrierenden Solar-Fotovoltaik-Teilmoduls nach einem der Ansprüche 1 bis 3, wobei das Material der Ableitungsschicht Graphen ist.

7. Verfahren zur Herstellung eines konzentrierenden Solar-Fotovoltaik-Teilmoduls nach einem der vorhergehenden Ansprüche, wobei das transparente Verkapselungsmaterial und die transparente Schutzschicht die Ableitungsschicht über deren gesamte Fläche bedecken, um sie zu schützen.

8. Verfahren zur Herstellung eines konzentrierenden Solar-Fotovoltaik-Teilmoduls nach einem der vorhergehenden Ansprüche, wobei die Ableitungsschicht die gesamte Fläche der zweiten Seite des Strukturelements bedeckt.

## Claims

1. A method for manufacturing a concentrating photovoltaic solar sub-module equipped with a reflective face having a concave predefined geometric shape, **characterised in that** it comprises laminating, in a single step, a multi-layer assembly comprising in succession:
- a structural element (F, P, RD) equipped with a reflective first face (F) and a second face, opposite the first;
- a dissipative layer (FG) of a material with a thermal conductivity which is higher than that of the material from which the structural element is composed, said dissipative layer being placed on the second face of the structural element;
- a layer of encapsulant (C) or of adhesive;
- a photovoltaic receiver (R), the layer of encapsulant or of adhesive being placed between the dissipative layer and the receiver;
- a layer made of transparent encapsulating material (E), covering at least the entire surface of the photovoltaic receiver; and
- a transparent protective layer (FAV) covering the layer made of transparent encapsulating material;
and **in that**, during the lamination, the reflective face of the structural element is shaped by being brought into contact with a convex surface of a counter-mold (CF), in order to obtain the reflective face of concave predefined geometric shape.

2. The method for manufacturing a concentrating photovoltaic solar sub-module according to the preceding claim, wherein the concave predefined geometric shape of said reflective face is parabolic.

3. The method for manufacturing a concentrating photovoltaic solar sub-module according to one of the preceding claims, wherein said structural element is made of composite material.

4. The method for manufacturing a concentrating photovoltaic solar sub-module according to one of the preceding claims, wherein said material of the dissipative layer is graphite.

5. The method for manufacturing a concentrating photovoltaic solar sub-module according to the preceding claim, wherein said graphite sheet has a thickness comprised between 50 µm and 500 µm.

6. The method for manufacturing a concentrating photovoltaic solar sub-module according to one of claims 1 to 3, wherein said material of the dissipative layer is graphene.

7. The method for manufacturing a concentrating photovoltaic solar sub-module according to one of the preceding claims, wherein said transparent encapsulating material and said transparent protective layer cover the entire surface of said dissipative layer, so as to protect it.

8. The method for manufacturing a concentrating photovoltaic sub-module according to one of the preceding claims, wherein said dissipative layer covers the entire surface of the second face of the structural element.
